Europäisches Patentamt

European Patent Office

Office européen des brevets

(11) Publication number: **0 131 463**
**B1**

# (12) EUROPEAN PATENT SPECIFICATION

(45) Date of publication of patent specification: **15.03.89**

(21) Application number: **84304668.1**

(22) Date of filing: **09.07.84**

(51) Int. Cl.⁴: **H 01 L 27/02**

(54) Masterslice semiconductor device.

(30) Priority: **09.07.83 JP 125288/83**
**09.07.83 JP 125289/83**

(43) Date of publication of application:
**16.01.85 Bulletin 85/03**

(45) Publication of the grant of the patent:
**15.03.89 Bulletin 89/11**

(84) Designated Contracting States:
**DE FR GB**

(56) References cited:
**US-A-4 412 237**

**PATENTS ABSTRACTS OF JAPAN, vol. 7, no.
154 (E-185)1299r, 6th July 1983; & JP - A - 58 64
047 (NIPPON DENKI K.K.) 16-04-1983**

**ELECTRONICS INTERNATIONAL, vol. 56, no. 3,
February 1983, pages 86-87, New York, US; C.
COHEN: "Gate array needs fewer gates for
RAM"**

**PATENTS ABSTRACTS OF JAPAN, vol. 7, no.
200 (E-196)1345r, 3rd September 1983; & JP - A
- 58 97 847 (NIPPON DENKI K.K.) 10-06-1983**

(73) Proprietor: **FUJITSU LIMITED**
**1015, Kamikodanaka Nakahara-ku
Kawasaki-shi Kanagawa 211 (JP)**

(72) Inventor: **Sato, Shinji c/o Fujitsu Limited
Patent Department 1015 Kamikodanaka
Nakahara-ku
Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

## Description

The present invention relates to a semiconductor device of a large scale integration (LSI) and, more specifically relates to a so-called masterslice semiconductor device, such as a gate array, fabricated with a large number of transistors arranged in rows and columns on a semiconductor substrate.

Masterslice semiconductor technology is proposed as a means for providing custom-tailored large scale integrated semiconductor devices at a low cost and within a short turnaround time. That is, a large number of transistors and resistors, which transistors and resistors are formed in a semiconductor chip in advance, and are thereafter interconnected by the use of masks having wiring patterns necessary for realizing a functional circuit to meet each customer's specific requirements. In a masterslice semiconductor device, the transistors are usually arranged so as to constitute a number of unit groups called basic cells having each the same pattern. An exemplary basic cell configuration and circuits comprised of basic cells are disclosed in United States Patent 4,412,237 issued October 25, 1983.

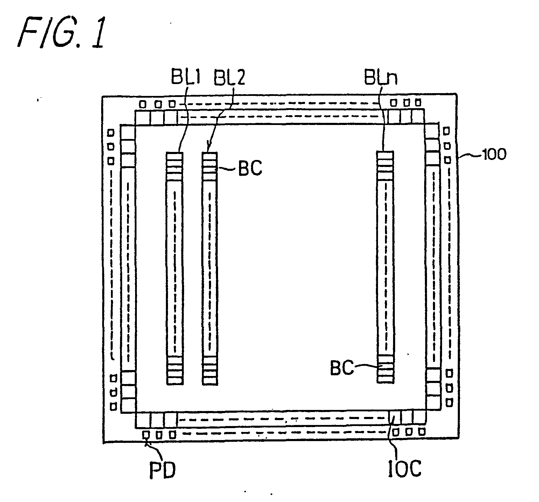

Figure 1 is a plan view showing an exemplary bulk pattern of a conventional gate array formed by use of masterslice technology.

As illustrated in Figure 1, on a semiconductor substrate chip 100, basic cells BC are arranged in columns to constitute basic cell arrays $BL_1$, $BL_2$, ... $BL_n$. Each of the basic cells BC is, in general, comprised of at least a pair of p-channel and n-channel transistors. The basic cell arrays are arranged with a specified spacing in the row direction. At the periphery of the chip 100, there is a pad region which is allotted for a plurality of pads PD, used as terminals to external circuitry, and an input/output region which is allotted for the input/output cells IOC, each containing an input/output circuit. As described later, the space between adjacent basic cell arrays is used for distributing wiring lines interconnecting basic cells located in the same basic cell array and/or basic cells located in different basic cell arrays.

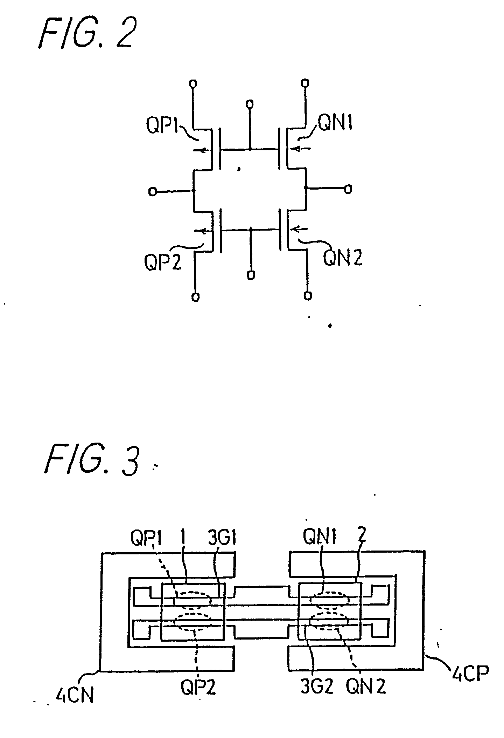

Figure 2 is an equivalent circuit diagram presenting an exemplary circuit included in a single basic cell of a previously proposed masterslice semiconductor device. The basic cell is comprised of a couple of p-channel transistors $QP_1$ and $QP_2$ whose sources or drains are connected to one another to form a single common source or drain, and a couple of n-channel transistors $QN_1$ and $QN_2$ whose sources or drains are connected to each other to form another single common source or drain. The gates of the p-channel transistor $QP_1$ and n-channel transistor $QN_1$ are connected to one another to form a single common gate and the gates of the p-channel transistor $QP_2$ and n-channel transistor $QN_2$ are connected to one another to form another single common gate.

Figure 3 is a plan view illustrating an exemplary bulk pattern of the basic cell for embodying the circuit as shown in Figure 2. In Figure 3, the sources and drains of p-channel transistor $QP_1$ and $QP_2$ are formed in a p-type region 1, and the sources and drains of the n-channel transistors are formed in an n-type region 2. A polysilicon gate electrode $3G_1$, which extends to/along one of the gate channels in each of the p-type region 1 and the n-type region 2, forms a single common gate of the p-channel transistor $QP_1$ and n-channel transistor $QN_1$, while a polysilicon gate electrode $3G_2$, which extends to/along another gate channel in each of the p-type region 1 and n-type region 2, forms a single common gate of the p-channel transistor $QP_2$ and n-channel transistor $QN_2$. 4CP and 4CN respectively designate a p-type contact region and a n-type contact region, which regions are used for keeping portions of the semiconductor substrate at specified potentials.

A number of basic cells as shown in Figures 2 and 3 are disposed along columns in a semiconductor chip, hence forming a plurality of arrays called basic cell arrays. The basic arrays are arranged one alongside another with a specified spacing therebetween along a row direction of the semiconductor substrate. Such basic cells are interconnected by aluminum layer wiring lines, then a desired LSI circuit network is completed.

In a masterslice semiconductor device, the LSI circuit network is formed of a number of elementary circuit blocks, in general, including 2-input NAND gate, 2-input NOR gate and/or a flip-flop circuit. Each of the elementary circuits is organized by using one or a plurality of such basic cells as shown in Figures 2 and 3. The area occupied by the basic cells constituting each elementary circuit is referred to as a unit cell.

Previously, each such unit cell has comprised basic cells successively arranged in a single basic cell array.

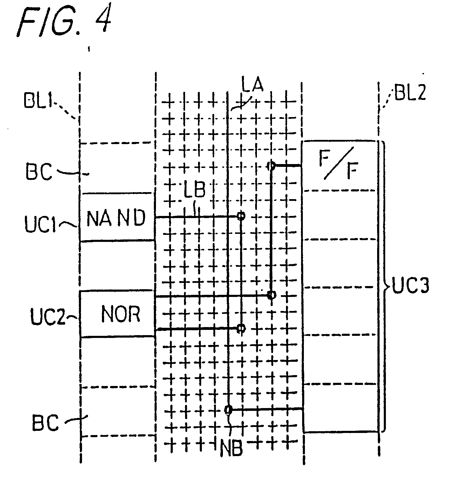

Figure 4 is a plan view of a partial bulk pattern of unit cells formed with basic cell arrays and wiring lines interconnecting the unit cells. In Figure 4, unit cells $UC_1$ and $UC_2$, which are a NAND gate and a NOR gate, respectively, are comprised of basic cells in the basic cell array $BL_1$, while unit cell $UC_3$, which includes a flip-flop circuit F/F, is comprised of basic cells in the basic cell array $BL_2$. The basic cells in a unit cell are interconnected by use of so-called double-layer aluminum metallization technology. The wiring lines interconnecting the basic cells within a unit cell are permitted to pass through/over the relevant basic cells. Interconnection among unit cells is also accomplished by use of double-layer aluminum metallization technology, however, the wiring lines must be formed in the space between the adjacent basic cell arrays. This limitation is imposed by the performance of the present CAD (Computer Aided Design) systems employed for designing the layout of the circuit network on a masterslice semiconductor chip.

These wiring lines formed in the space between adjacent basic cell arrays are assumed to be arranged on a virtual grid having a constant pitch. In Figure 4, a wiring line interconnecting the NOR

gate (unit cell $UC_2$) and the flip-flop circuit in unit cell $UC_3$, for example, consists of vertical and horizontal segments (LA and LB) which are laid on the virtual grid situated between two adjacent basic cell arrays $BL_1$ and $BL_2$. The virtual grid is, of course, not apparent in the actual pattern but only exists as a logical image in the process of CAD. If it is assumed that there are nine grid lines in the vertical direction (the longitudinal direction of the basic cell arrays $BL_1$ and $BL_2$), nine wiring lines such as LA can be accommodated in the space between adjacent arrays. Such space is referred to as a wiring region of nine channels. This is the same as to the grid lines in the transverse direction.

According to the double-layer aluminum metallization as described above, each segment LA extending along the longitudinal direction of the basic cell arays is fabricated from a first aluminum layer, while each segment LB extending perpendicularly to the longitudinal direction is fabricated from a second aluminum layer, in general. The segments LA and LB are connected to each other at crossover points marked with circles, via through-holes formed in an insulating layer therebetween. Thus, interconnection between the unit cells in adjacent basic cell arrays is completed.

As mentioned before, in the previous masterslice technology, basic cells constituting a unit cell must belong to one basic cell array. That is, a unit cell must be one dimensional in terms of the arrangement of the basic cells. This is mainly due to the performance of the present CAD system employed for the design of a circuit network in a masterslice semiconductor device. To manufacture a final masterslice semiconductor device within a required short turnaround time, it is necessary to minimize the design parameters which are defined in the CAD system, and the one dimensional unit cell is requisite to this requirement as for the previous masterslice technology. Thus, a unit cell is organized in a basic cell array, and interconnections between adjacent basic cell arrays are conducted on unit cell basis, not on a basic cell basis.

As the result of the restriction that a unit cell must be one dimensional in the sense mentioned above, the wiring lines including those for interconnecting basic cells in a unit cell and those for interconnecting the unit cells become long, and further, the variety and the scale of unit cells are limited by the number of channels available in the space between adjacent basic cell arrays. As a wiring lines becomes longer, the propagation delay of signals in a circuit network formed in a masterslice semiconductor device is increased. Such propagation delay requires countermeasures such as implementation of block buffer circuits. A block buffer circuit expends a number of transistors, eleven transistors for each block buffer circuit for example, despite its high driving power sufficient for compensating for propagation delay.

Furthermore, in a masterslice semiconductor device comprised of basic cells as shown in Figures 2 and 3, some kinds of unit cells, such as a RAM (Random Access Memory) cell, a transmission gate circuit and a clocked gate circuit, can not be formed without leaving one or more redundant transistors in some basic cells constituting the unit cells. For example, four basic cells as shown Figure 3 are used to constitute a single 8-transistor RAM cell. However, only a half of the total 16 transistors in the four basic cells are utilized in the RAM cell and the other half of the transistors are made inactive. As for a transmission gate circuit. That is, two transmission gates can be formed from each basic cell, but they can not operate independently of each other, accordingly, except for some special applications, one of the two transmission gates is redundant. In a clocked gate circuit comprised of two of the basic cells, a half of the total of eight transistors is unused and made inactive. The presence of redundant transistors reduces the integration density of the LSI circuit network on the masterslice semiconductor chip.

According to the present invention there is provided a masterslice semiconductor device, with or without wiring patterns, having basic cells on a semiconductor substrate, the basic cells being arranged along rows and columns on the semiconductor substrate to constitute a plurality of basic cell arrays, each aligned in the column direction, disposed one after another in the row direction, wherein each basic cell comprises:

a transistor pair including a first p-channel transistor ($QP_{10}$) and a first n-channel transistor ($QN_{10}$), which are formed adjacent to one another, the gates of the first p-channel transistor and the first n-channel transistor being formed to extend in line with one another;

a second p-channel transistor ($QP_{20}$) formed to one longitudinal end of the transistor pair; and

a second n-channel transistor ($QN_{20}$) formed to the other longitudinal end of the transistor pair.

An embodiment of the present invention can provide a masterslice semiconductor device comprised of basic cells having a bulk pattern which permits construction of unit cells ranging over plural basic cell arrays.

That is, it is possible to constitute a unit cell beyond the space between the adjacent basic cell arrays, that is, a unit cell can be two dimensional in terms of the arrangement of the basic cells, and the above inconveniences in the previous unit cell configuration can be avoided and freedom in the circuit design on a masterslice semiconductor device can be substantially increased.

An embodiment of the present invention can provide a masterslice semiconductor device with which the occurrence of redundant transistors in a unit cell is substantially eliminated.

In an embodiment of the present invention a masterslice semiconductor device is constituted by incorporating additional p-channel and n-channel MIS (Metal Insulator Semiconductor) transistors into each basic cell comprised of at least one transistor pair having a p-channel MIS transistor and/or an n-channel MIS transistor. That is, the basic cell of the present invention fundamentally comprises a transistor pair including each one of first p-channel and first n-channel transistors and each one of second p-channel and n-channel transistors. The first p-channel and n-channel transistors are formed to be adjacent each other in the semiconductor substrate. The second p-channel transistor is formed at a place adjacent to one longitudinal end of the transistor pair in the semiconductor substrate, while the second n-channel transistor is formed at a place adjacent to the other longitudinal end of the transistor pair in the semiconductor substrate. The gates of said first p-channel and n-channel transistors are formed to extend in line with each other along the rows or columns of the semiconductor substrate, and the gates of said second p-channel and n-channel transistors are formed to extend along the columns of the semiconductor substrate.

The occurrence of the redundant transistors in the previous masterslice semiconductor device arises because each of the paired p-channel and n-channel transistors, $QP_1$ and $QN_1$, and $QP_2$ and $QN_2$ (see Figures 2 or 3), have a single common gate, however, the basic cell configuration in the present invention can substantially eliminate such redundant transistors, no matter whether the paired p-channel and n-channel transistors preserve the common gate or not.

Reference is made, by way of example, to the accompanying drawings, in which:

Figure 1 is a plan view showing an exemplary bulk pattern of a previously proposed gate array formed by use of masterslice technology;

Figure 2 is an equivalent circuit diagram of an example of a circuit included in a single basic cell of a previously proposed masterslice semiconductor device;

Figure 3 is a plan view illustrating an exemplary bulk pattern of a basic cell embodying the circuit as shown in Figure 2;

Figure 4 is a partial plan view illustrating the layout of unit cells in two adjacent basic cell arrays and the layout of wiring lines for interconnecting the unit cells.

Figure 5 is an equivalent circuit diagram showing a fundamental basic cell configuration according to an embodiment of the present invention;

Figures 6(a) and 6(b) are plan views illustrating exemplary bulk patterns each embodying the circuit shown in Figure 5;

Figure 7 is an equivalent circuit diagram of another basic cell according to an embodiment of the present invention;

Figure 8 is a plan view illustrating an exemplary bulk pattern embodying the circuit shown in Figure 7;

Figure 9 is an equivalent circuit diagram of a RAM cell;

Figure 10 is a plan view illustrating an exemplary distribution of wiring lines, embodying the RAM cell by using the basic cell shown in Figure 8;

Figure 11 is an equivalent circuit diagram of a transmission gate;

Figure 12 is a plan view illustrating an exemplary bulk pattern embodying the circuit of the transmission gate shown in Figure 11;

Figure 13 is an equivalent circuit diagram of a clocked gate;

Figure 14 is a plan view illustrating an exemplary bulk pattern embodying the clock gate circuit shown in Figure 13;

Figure 15 is a plan view of a bulk pattern presenting further another embodiment of the present invention;

Figure 16 is a plan view of a bulk pattern presenting still another embodiment of the present invention;

Figure 17 is an equivalent circuit diagram of a couple of RAM cells;

Figure 18 is a plan view of an exemplary bulk pattern embodying the circuit of the RAM cells shown in Figure 17;

Figure 19 is a plan view of a partial bulk pattern illustrating the additional transistors in two adjacent basic cell arrays; and

Figure 20 is a plan view of a conceptual bulk pattern for explaining the concept of a new basic cell array comprising the additional transistors.

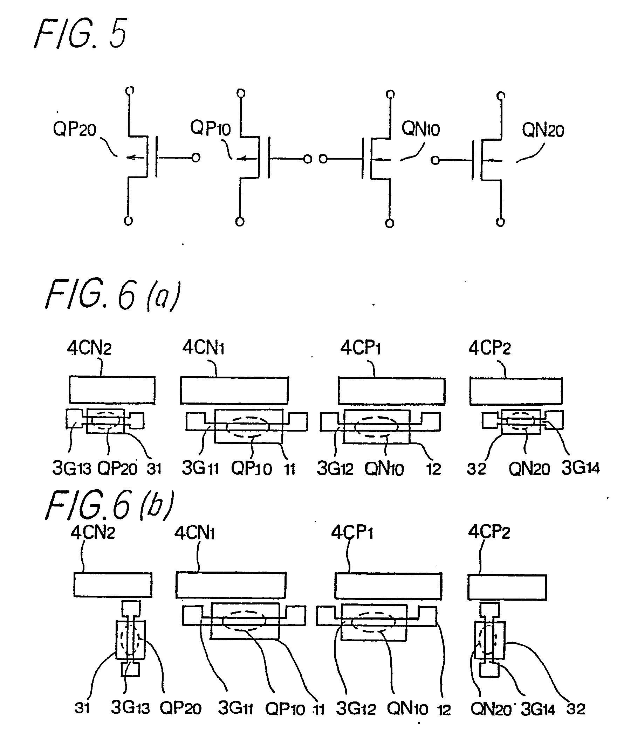

Figure 5 is an equivalent circuit diagram showing a fundamental basic cell configuration of an embodiment of the present invention, and Figures 6(a) and 6(b) are plan views illustrating exemplary bulk patterns each embodying the circuit shown in Figure 5. In Figures 5, 6(a) and 6(b), a first p-channel transistor $QP_{10}$ and a first n-channel transistor $QN_{10}$, which are arranged adjacently to each other in a row direction of a semiconductor substrate, constitute a transistor pair. Referring to Figures 6(a) and 6(b), the respective gates of the first p-channel and n-channel transistors $QP_{10}$ and $QN_{10}$, are extended in line with each other along the row direction. At a position adjacent to one longitudinal end of the transistor pair comprising the first p-channel and n-channel transistors $QP_{10}$ and $QN_{10}$, an additional transistor, for example, a p-channel transistor $QP_{20}$, is formed, and at a position adjacent to the other longitudinal end of the transistor pair, another additional transistor having a channel of opposite conduction type to the former additional transistor, therefore, an n-channel transistor $QN_{20}$ in Figures 5, 6(a) and 6(b), is formed.

In Figure 6(a), respective gates $3G_{13}$ and $3G_{14}$ of two additional transistors (referred to as the second p-channel and n-chanel transistors, hereinafter) $QP_{20}$ and $QN_{20}$, are laid out in line with the line of extension of respective gates $3G_{11}$ and $3G_{12}$ of the first p-channel transistor $QP_{10}$ and the first n-channel transistor $QN_{10}$. In Figure 6(b), the respective gates $3G_{13}$ and $3G_{14}$ of the second p-channel transistor $QP_{20}$ and the second n-channel transistor $QN_{20}$ are laid out in parallel to each other and perpendicularly to the line of extension of the respective gates $3G_{11}$ and $3G_{12}$ of the first p-channel transistor $QP_1$ and the first n-

channel transistors $QN_1$.

In both Figures 6(a) and 6(b), reference numerals 11 and 31 designate respective p-type region of the p-channel transistors $QP_{10}$ and $QP_{20}$, whilst the reference numerals 12 and 32 designate respective n-type regions of the n-channel transistor $QN_{10}$ and $QN_{20}$.

Further, reference characters $4CP_1$ and $4CP_2$ denote p-type ($p^+$) contact regions and reference characters $4CN_1$ and $4CN_2$ denote n-type ($n^+$) contact regions. These contact regions are used for keeping every portion of the semiconductor substrate at each specified potential, as mentioned before.

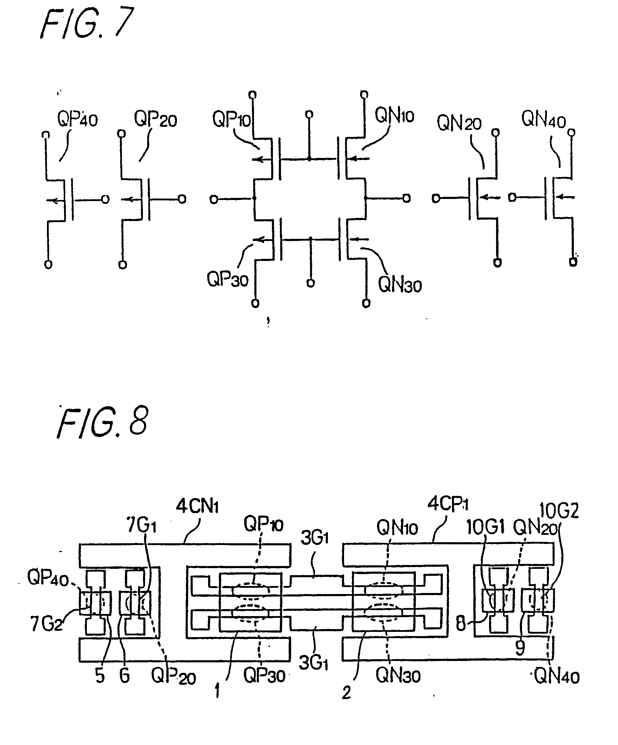

Figure 7 is an equivalent circuit diagram of another basic cell configuration employed in an embodiment of the present invention, and Figure 8 is a plan view of an exemplary bulk pattern embodying the circuit shown in Figure 7. It may be considered, on comparison with Figures 5 and 6(b), that the basic cell shown in Figures 7 and 8 further includes another transistor pair comprising a third p-channel transistor $Q_{30}$ and a third n-channel transistor $QN_{30}$, and further additional transistors, i.e., a fourth p-channel transistor $QP_{40}$ and a fourth n-channel transistor $QN_{40}$. The first p-channel and n-channel transistors $QP_{10}$ and $QN_{10}$ have a single common gate $3G_1$, and the third p-channel and n-channel transistors $QP_{30}$ and $QN_{30}$ have another single common gate $3G_2$. The sources or drains of the first and the third p-channel transistors $QP_{10}$ and $QP_{30}$ form a single common source or drain in a p-type region 1, and the sources or drains of the first and the third n-channel transistors $QN_{10}$ and $QN_{30}$ form another single common source or drain in a n-type region 2.

Referring to Figure 8, the pair of the third p-channel and n-channel transistors $QP_{30}$ and $QN_{30}$ are arranged in parallel to the first transistor pair comprising the first p-channel and n-channel transistors $QP_{10}$ and $QN_{10}$ and the gates of the third p-channel and n-channel transistors $QP_{30}$ and $QN_{30}$ are formed to extend in line with each other in the row direction of the semiconductor substrate. The second p-channel and n-channel transistors $QP_{20}$ and $QN_{20}$ and the fourth p-channel and n-channel transistors $QP_{40}$ and $QN_{40}$ are arranged along a line passing midway between the first transistor pair comprising the first p-channel and n-channel transistors $QP_{10}$ and $QN_{10}$ and the other transistor pair comprising the third p-channel and n-channel transistors $QP_{30}$ and $QN_{30}$. The respective gates $7G_1$ and $7G_2$ of the second and the fourth p-channel transistors $QP_{20}$ and $QP_{40}$ are formed to extend in parallel to each other along the column direction of the semiconductor substrate, and the respective gates $10G_1$ and $10G_2$ of the second and the fourth n-channel transistors $QN_{20}$ and $QN_{40}$ are formed to extend in parallel to each other along the column direction of the semiconductor substrate. Contact regions of the p-channel transistors $QP_{10}$, $QP_{20}$, $QP_{30}$, and $QP_{40}$ are united into a single common n-type ($n^+$) contact region $4CN_1$, and those of the n-channel transistors $QN_{10}$, $QN_{20}$, $QN_{30}$ and $QN_{40}$ are united into a single common p-type ($p^+$) contact region $4CP_1$. Separate $n^+$ contact regions may be provided for $QP_{10}$, $QP_{30}$ and for $QP_{20}$, $QP_{40}$. Separate $p^+$ contact regions may be provided for $QN_{10}$, $QN_{30}$ and $QN_{20}$, $QN_{40}$. It will be appreciated that $n^+$ and $p^+$ contact regions separate second transistors from the transistor pairs. Similar provisions regarding contact regions may be made in other embodiments of the invention. In Figure 8, the reference numerals 5 and 6 denote p-type regions for the p-channel transistors $QP_{20}$ and $QP_{40}$, respectively, and the reference numerals 8 and 9 denote n-type regions for the n-channel transistors $QN_{20}$ and $QN_{40}$, respectively. In each respective region, the sources and drains of the transistors $QP_{20}$, $QP_{40}$, $QN_{20}$ and $QN_{40}$ are formed.

As is obvious in Figure 8, the basic cell partially comprises the same bulk pattern as that shown in Figure 3.

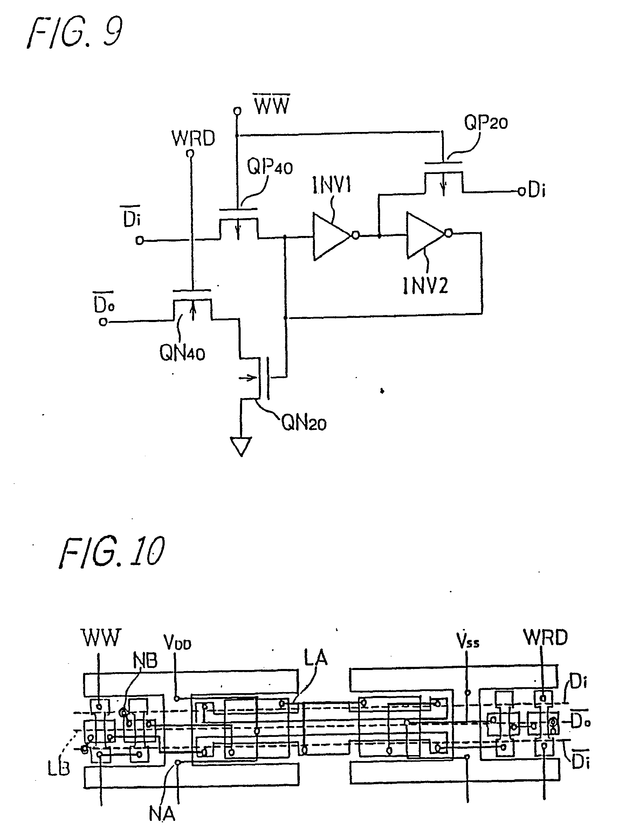

Figure 9 is an equivalent circuit diagram of a RAM cell and Figure 10 is a plan view illustrating an exemplary distribution of wiring lines for embodying the RAM cell by using a basic cell shown in Figure 8.

Inverters $INV_1$ and $INV_2$ in Figure 9, are respectively formed of the transistor pair comprising p-channel transistor $QP_{10}$ and n-channel transistor $QN_{10}$, and another transistor pair comprising n-channel transistor $QP_{30}$ and n-channel transistor $QN_{30}$ in Figure 8. In Figures 9 and 10, reference characters WRD and $\overline{WW}$ designate a read-out word line and a write-in word line, respectively. Input data signals and inverse input data signals are supplied to terminals denoted by reference characters Di and $\overline{Di}$ respectively, and inverse output data signals are output from a terminal denoted by reference character $\overline{Do}$. In Figure 10, LA indicates wiring lines (thick solid lines) fabricated from a first layer in double-layer aluminum metallization, and LB indicates a wiring lines (thick broken lines) fabricated from second layer in the double-layer aluminum metallization. The wiring lines LA and LB have contacts, at the specified portions on the surface, with the semiconductor substrate, each of which portions is indicated by a small circle. The wiring lines LA and LB are connected to one another via through-holes formed in an insulating layer therebetween at specified cross-over points indicated by the double circles. In Figure 10, $V_{DD}$ and $V_{SS}$ designate a positive potential source and negative potential (usually earth potential) source.

As described above, the RAM cell shown in Figure 9 can be fabricated from one basic cell in an embodiment of the present invention, although the area occupied by this basic cell is larger than that occupied by the basic cell as shown in Figure 3 due to the presence of the respective second and fourth p-channel and n-channel transistors. Even assuming the basic cell of the embodiment of the present invention occupies about twice the area of the basic cell of Figure 3, the area necessary to form the RAM cell is one half of the total area occupied by the four Figure 3 basic cells necessary for constituting an equivalent RAM cell.

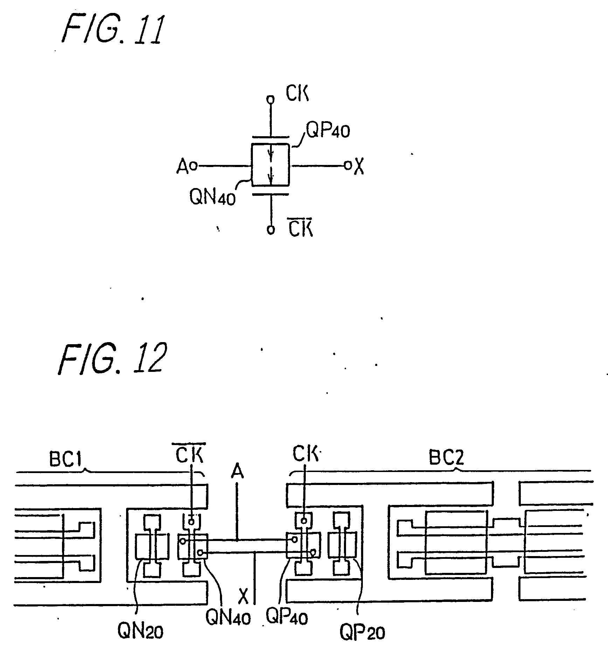

Figure 11 is an equivalent circuit diagram of a transmission gate, and Figure 12 is a plan view illustrating an exemplary bulk pattern embodying the circuit of the transmission gate shown in Figure 11. In Figures 11 and 12, input signals, clock signals and inverted clock signals are supplied to the respective terminals denoted by reference signs A, CK and $\overline{CK}$, and output signals are output from a terminal denoted by reference sign X. As shown in Figure 12, the transmission gate can be comprised of a fourth p-channel transistor $QP_{40}$ in a basic cell $BC_2$ and a fourth n-channel transistor $QN_{40}$ in a basic cell $BC_1$. The basic cell $BC_1$ and basic cell $BC_2$ belong to two respective adjacent basic cell arrays, but have the same bulk pattern as shown in Figure 8. The remaining transistors in each of the basic cells $BC_1$ and $BC_2$ can be utilized to constitute other unit cells, an elemental circuit, which usually functions in cooperation with the transmission gate. If the respective transistors $QP_{20}$ and $QN_{20}$ in the basic cells $BC_1$ and $BC_2$ are not used, the area occupied by these transistors can naturally be utilized as wiring regions. Thus, a transmission gate can be formed without occurrence of any redundant transistors.

As explained above, the transmission gate, as a unit cell, can be organized by use of basic cells belonging to two adjacent basic cell arrays, in other words, a unit cell can be two-dimensional in terms of the arrangement of basic cells. This feature is provided by the novel configuration of the basic cell of the embodiment of the present invention. That is, in the basic cell of the embodiment of the present invention, the additional transistors (the respective second and fourth transistors) at each longitudinal end of the transistor pairs are formed to occupy the part of the space which has previously been exclusively used for distributing wiring lines between adjacent basic cell arrays. Hence, interconnection of the basic cells belonging to adjacent basic cell arrays can be accomplished more easily thanks to the additional transistors in the basic cells and the shorter wiring lines. The additional transistors can functionally constitute a unit cell ranging over the adjacent basic cell arrays. Further, the versatility of the additional transistors, which have individual gates and occupy individual source region and drain regions, increases freedom for designing unit cells.

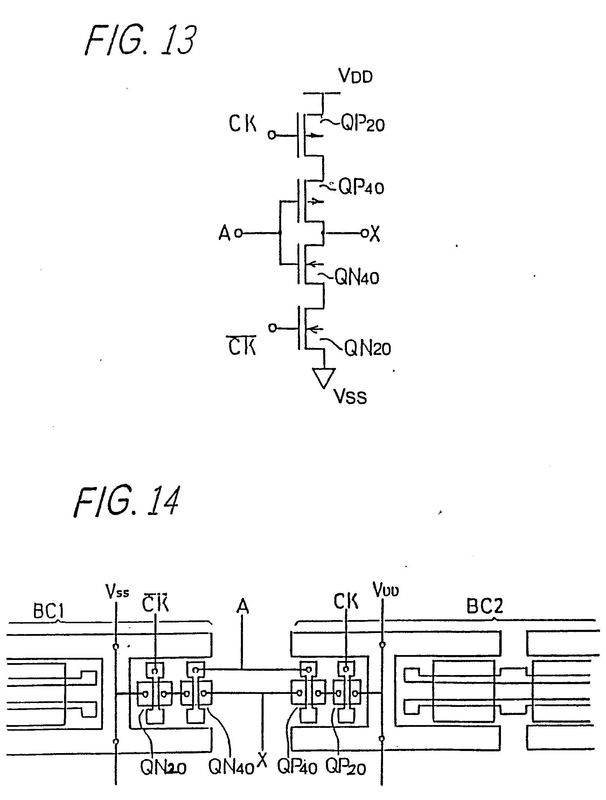

Figure 13 is an equivalent circuit diagram of a clocked gate, and Figure 14 is a plan view illustrating an exemplary bulk pattern embodying the circuit of the clocked gate shown in Figure 13, by using the basic cells of an embodiment of the present invention. The clocked gate shown in Figure 13 comprises two p-channel transistors and two n-channel transistors connected in series between positive potential source $V_{DD}$ and negative potential source $V_{SS}$. Referring to Figure 14, for these transistors, second and fourth p-channel transistors $QP_{20}$ and $QP_{40}$ in a basic cell $BC_2$ and second and fourth n-channel transistors $QN_{20}$ and $QN_{40}$ in the basic cell $BC_1$ are employed. The remaining transistors in each of the basic cells $BC_1$ and $BC_2$ can be utilized for constituting another unit cell, therefore, no redundant transistors result, as compared with a previous masterslice semiconductor device wherein two basic cells as shown in Figure 3 are required to constitute an equivalent clocked gate, and wherein there occur four redundant transistors, as mentioned before.

Other circuits of unit cells including 2-input NAND gates, inverter circuits, etc. can be organized by use of the additional transistors in the basic cell of embodiments of the present invention. If these additional transistors are not utilized for constituting a unit cell, the region occupied by the additional transistors can be used exclusively for distributing wiring lines, as in the wiring region of the previous masterslice semiconductor device.

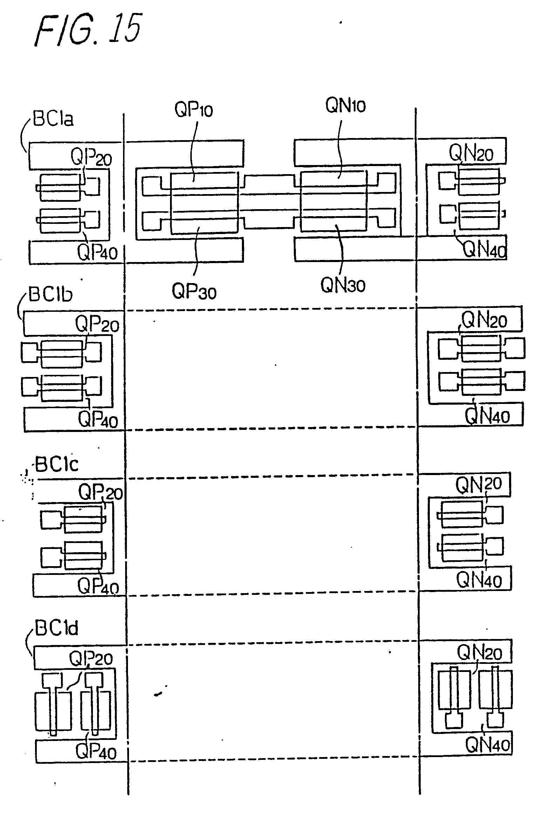

Figure 15 is a plan view of a bulk pattern illustrating another embodiment of the present invention. Referring to Figure 15, a basic cell array comprises four kinds of basic cells, $BC_{1a}$, $BC_{1b}$, $BC_{1c}$ and $BC_{1d}$, each having a configuration according to this embodiment of the present invention.

In basic cells $BC_{1a}$, $BC_{1b}$ and $BC_{1c}$, the arrangement of additional transistors $QP_{20}$ and $QN_{20}$ with respect to the transistor pair comprising transistors $QP_{10}$ and $QN_{10}$, and the arrangement of the additional transistors, $QP_{40}$ and $QN_4$, with respect to the transistor pair comprising transistors $QP_{30}$ and $QN_{30}$, is similar to that shown in Figure 6(a), and the gates of the additional transistors $QP_{20}$ and $QN_{20}$ are formed to extend in line with the line of extension of the gate of the transistor pair comprising transistors $QP_{10}$ and $QN_{10}$, and the gates of the additional transistors, $QP_{40}$ and $QN_{40}$ are formed to extend in line with the line of extension of the gate of the transistor pair comprising transistors $QP_{30}$ and $QN_{30}$. The gates of the additional transistors $QP_{20}$ and $QP_{40}$ are in parallel to each other, and the gates of the additional transistors $QN_{20}$ and $QN_{40}$ are in parallel to each other. However, in the basic cell $BC_{1d}$, the arrangement of the additional transistors $QP_{20}$, $QN_{20}$, $QP_{40}$ and $QN_{40}$ with respect to both of the transistor pairs is similar to that shown in Figure 8. A difference between the basic cells $BC_{1a}$, $BC_{1b}$ and $BC_{1c}$ lies in the shape of the gate electrodes, which are of three different types, as is clear in Figure 15. The one or two tubs (tabs) at each gate electrode are used as contact terminals for wiring. In the basic cells $BC_{1a}$, $BC_{1c}$ and $BC_{1d}$, single-tab gates are used for the additional transistors $QP_{20}$, $QP_{40}$, $QN_{20}$ and $QN_{40}$, whilst two tab gates are used for the additional transistors in the basic cell $BC_{1b}$.

Moreover, the location of the tabs of the single-tab gates differ between the basic cells as shown in Figure 15.

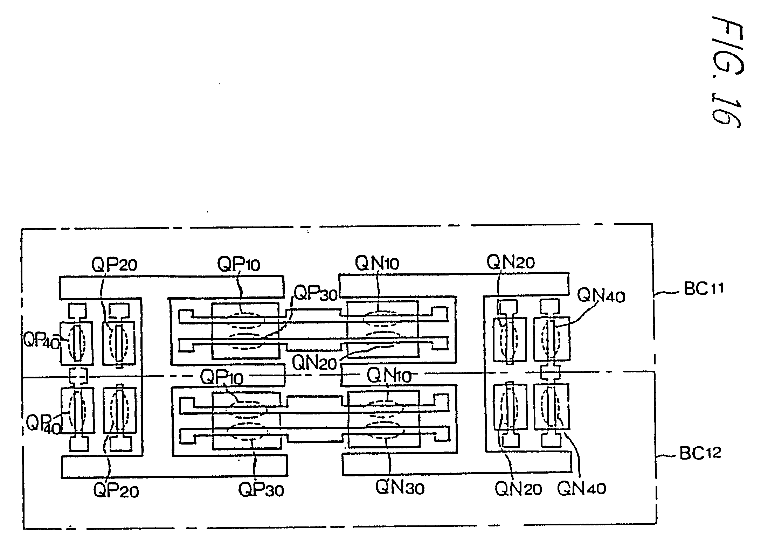

Figure 16 is a plan view of a bulk pattern illustrating another embodiment of the present invention. In Figure 16, each of basic cells $BC_{11}$ and $BC_{12}$, which belong to a same basic cell array, has the same configuration as the basic cell shown in Figure 8. However, the respective fourth p-channel transistors $QP_{40}$ in the basic cells $BC_{11}$ and $BC_{12}$ have a single common gate, and also the respective forth n-channel transistors $QN_{40}$ in the basic cells $BC_{11}$ and $BC_{12}$ have another single common gate. Therefore, the contact regions $4CN_1$ and $4CP_1$ are not extended to the portions between these additional transistors.

Such commmon gates is provided for the additional transistor $QP_{40}$ or $QN_{40}$ in pairs of basic cells which are successively arranged in a basic cell array, but not provided for successive cells belonging to different such pairs, for example not provided for the respective fourth p-channel transistors $QP_{40}$ in the basic cell $BC_{12}$ and that in the next basic cell (not shown). The advantage of the bulk pattern as shown in Figure 16 is explained in the following.

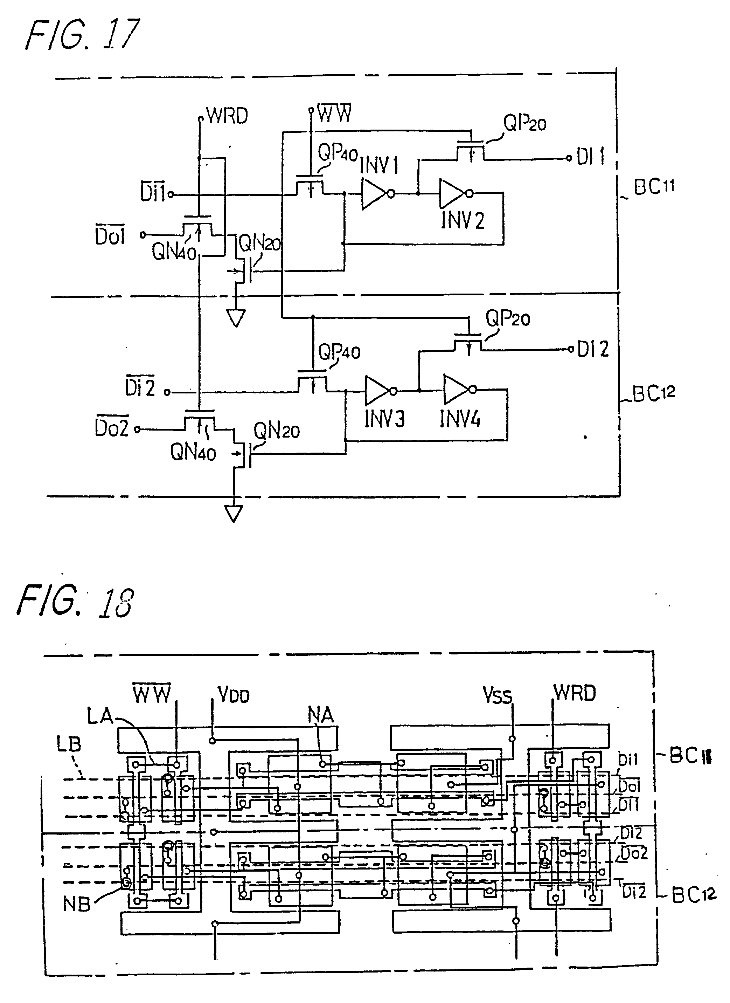

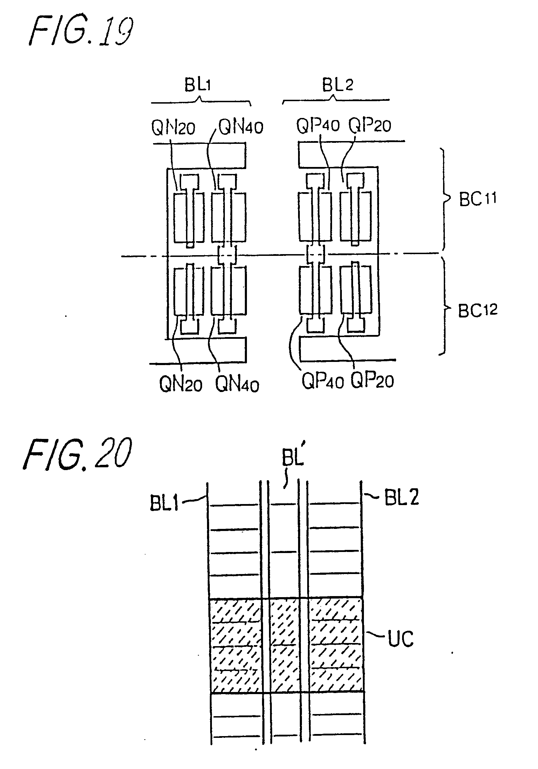

Figure 17 is an equivalent circuit diagram of two RAM cells, and Figure 18 is a plan view of an exemplary bulk pattern embodying the circuit of RAM cells shown in Figure 17. In Figures 17 and 18, reference characters WRD, $\overline{WW}$, $INV_1$ and $INV_2$ are used with the same meanings as in Figure 9 and 10. The reference characters $Di_1$ and $Di_2$ designate terminals for input data signals $Di_1$ and $Di_2$, respectively, the reference characters $\overline{Di}_1$ and $\overline{Di}_2$ designate terminals for inverted input data signals $\overline{Di}_1$ and $\overline{Di}_2$, respectively, and $\overline{Do}_1$ and $\overline{Do}_2$ designate the terminals for inverted output data signals, respectively, and $INV_3$ and $INV_4$ denote inverter circuits. In Figures 17 and 18, the inverter circuits $INV_1$ and $INV_2$ are formed from aforesaid transistor pairs in the basic cell $BC_{11}$, and the inverter circuits $INV_3$ and $INV_4$ are formed from aforesaid transistor pairs in the basic cell $BC_{12}$, according to the manner explained for Figures 9 and 10. In Figure 18, reference characters LA and LB designate the first wiring layer (indicated by thick solid lines) and the second wiring layer (indicated by thick dotted lines), respectively, wherein both wiring layers are fabricated by use of double-layer aluminum metallization technology. The reference character NA denotes contact portions (each indicated by a small circle) of the first aluminum wiring layer and the semiconductor substrate, and the reference character NB denotes the contact portions (each indicated by a doubled-circle) of the first aluminum wiring layer and the second aluminum wiring layer.

If the pair of the basic cells $BC_{11}$ and $BC_{12}$ is assumed as a single basic cell, the bulk pattern can constitute two bits of a RAM cell without the occurrence of any redundant transistors and the need of aluminum wirings for the interconnection between the fourth p-channel transistors $QP_{40}$ and the interconnection between the fourth n-channel transistors $QN_{40}$. Therefore, the masterslice comprised of such basic cells is highly suitable to the manufacture of custom RAMs.

Figure 19 is a plan view of a partial bulk pattern illustrating the fourth transistors in two adjacent basic cell arrays. Referring to Figure 19, the respective fourth p-channel transistors $QP_{20}$ and $QP_{40}$ in the basic cells $BC_{11}$ and $BC_{12}$, both of which belong to the basic cell array $BL_2$, can be assumed as a basic cell having a configuration similar to the basic cell shown in Figure 3. This is quite same as for the fourth n-channel transistors $QN_{20}$ and $QN_{40}$ in the basic cells $BC_{11}$ and $BC_{12}$, both of which belong to the basic cell array $BL_1$. Different from the basic cell of Figure 3, the newly introduced basic cell comprises transistors having channels of same conduction type, and in the basic cell, only one transistor pair is provided with a common gate, and none of the transistors shares a common source or drain with others.

The concept of the new basic cell suggests the existence of new basic cell array BL' between the basic cell arrays $BL_1$ and $BL_2$, as shown in Figure 20, a plan view of a conceptual bulk pattern presenting the new basic cell array. In Figure 20, the basic cell array BL' comprises two kinds of the newly introduced basic cells, as explained above with the reference of Figure 19. The bulk pattern in Figure 20 can, in one view, be considered as that the new basic cell array is inserted between two adjacent basic cell arrays comprising the prior art basic cells as shown in Figure 3.

The many features and advantages of the present invention are apparent from the detailed description, but it will be recognized by those skilled in the art that modificiations and variations may be affected within the spirit and scope of the present invention. For example, the entire region occupied by the additional transistors in any basic cell array can be used as a wiring region.

Furthermore, along rows, the arrangement of the p-channel and n-channel transistors constituting the transistor pair in any basic cell of the present invention may be optional among basic cell arrays, and the arrangement of the additional p-channel and n-channel transistors with respect to the transistor pair or pairs may also be optional, provided that the regularity of the arrangements are kept within each basic cell array. For instance, in a basic cell array, all of the p-channel transistors occupy the left-hand side positions against n-channel transistors, while, in any of the other basic cell arrays, vice versa.

A masterslice semiconductor device comprised of basic cells having additional transistors formed adjacent to the longitudinal end of transistor pair or pairs which have a configuration almost same as in the ordinary basic cell. The basic cells are arranged in columns of the semiconductor substrate they are formed in, and constitute a plurality of basic cell arrays.

Each of the additional transistors occupies an individual conduction region for source and drain and is provided with an individual gate electrode which extends in line with or perpendicularly to the line of extension of the gate of the transistor pair. The additional transistor occupy the space between adjacent basic cell arrays which are, in the previous masterslice semiconductor device, exclusively used for distributing wiring lines accordingly the width of the space is decreased. Because of the versatility of the additional transistors, and the reduced distance between adjacent basic cell arrays, a unit cells can be organized by using the basic cells belonging to adjacent basic cell arrays. The additional transistors are made inactive when the region which they occupy must be exclusively used for distributing interconnecting lines.

**Claims**

1. A masterslice semiconductor device, with or without wiring patterns, having basic cells on a semiconductor substrate, the basic cells being arranged along rows and columns on the semiconductor substrate to constitute a plurality of basic cell arrays, each aligned in the column direction, disposed one after another in the row direction, wherein each basic cell comprises:

a transistor pair including a first p-channel transistor ($QP_{10}$) and a first n-channel transistor ($QN_{10}$) which are formed adjacent to one another, the gates of the first p-channel transistor and the first n-channel transistor being formed to extend in line with one another;

a second p-channel transistor ($QP_{20}$) formed to one longitudinal end of the transistor pair; and

a second n-channel transistor ($QN_{20}$) formed to the other longitudinal end of the transistor pair.

2. A device as claimed in claim 1, wherein the gates of the second p-channel and n-channel transistors ($QP_{20}$, $QN_{20}$) are formed to extend in line with the line of extension of the gates of the first p-channel and n-channel transistors ($QP_{10}$, $QN_{10}$).

3. A device as claimed in claim 1 or 2, wherein the gates of the first p-channel and n-channel transistors ($QP_{10}$, $QN_{10}$) are commonly connected to one another by the same electrode material.

4. A device as claimed in claim 2 or 3, each basic cell further comprising:

a further transistor pair including a third p-channel transistor ($QP_{30}$) and a third n-channel transistor ($QN_{30}$), which are respectively aligned in parallel and adjacent to the first p-channel and n-channel transistors ($QP_{10}$, $QN_{10}$), the gates of the third p-channel and n-channel transistors ($QP_{30}$, $QN_{30}$) being formed to extend in line with each other;

a fourth p-channel transistor ($QP_{40}$) formed adjacent to one longitudinal end of the further transistor pair; and

a fourth n-channel transistor ($QN_{40}$) formed adjacent to the other longitudinal end of the further transistor pair; the fourth p-channel and n-channel transistors ($QP_{40}$, $QN_{40}$) being respectively aligned in parallel and adjacent to the second p-channel and n-channel transistors ($QP_{20}$, $QN_{20}$), the gates of the fourth p-channel and n-channel transistors ($QP_{40}$, $QN_{40}$) extending in line with the line of extension of the gates of the third p-channel and n-channel transistors ($QP_{30}$, $QN_{30}$).

5. A device as claimed in claim 4, wherein the gates of the third p-channel and n-channel transistors ($QP_{30}$, $QN_{30}$) are commonly connected to each other by the same electrode material.

6. A device as claimed in claim 4 or 5, wherein the sources or drains of the first and third p-channel transistors ($QP_{10}$, $QP_{30}$) are formed in a single p-type region (1) and the sources or drains of the first and third n-channel transistors ($QN_{10}$, $QN_{30}$) are formed in a single n-type region (2).

7. A device as claimed in claim 1, wherein the gates of the second p-channel and n-channel transistors ($QP_{20}$, $QN_{20}$) are aligned perpendicularly to the line of extension of the gates of the first p-channel and n-channel transistors ($QP_{10}$, $QN_{10}$).

8. A device as claimed in claim 7, wherein the gates of the first p-channel and n-channel transistors ($QP_{10}$, $QN_{10}$) are commonly connected to one another by the same electrode material.

9. A device as claimed in claim 7 or 8, each basic cell further comprising:

a further transistor pair including a third p-channel transistor ($QP_{30}$) and a third n-channel transistor ($QN_{30}$), which are respectively aligned in parallel and adjacent to the first p-channel and n-channel transistors ($QP_{10}$, $QN_{10}$), the gates of the third p-channel and n-channel transistors ($QP_{30}$, $QN_{30}$) being formed to extend in line with each other;

a fourth p-channel transistor ($QP_{40}$) formed neighboring one longitudinal end of the further transistor pair; and

a fourth n-channel transistor ($QN_{40}$) formed neighboring the other longitudinal end of the the further transistor pair; wherein the fourth p-channel and n-channel transistors are respectively aligned in parallel and adjacent to said second p-channel and n-channel transistors ($QP_{20}$, $QN_{20}$), and the gates of the fourth p-channel and fourth n-channel transistors ($QP_{40}$, $QN_{40}$) are formed to extend perpendicularly to the line of extension of the gates of the third p-channel and n-channel transistors ($QP_{30}$, $QN_{30}$).

10. A device as claimed in claim 9, wherein both of the second and fourth p-channel transistors ($QP_{20}$, $QP_{40}$) are formed to situate in a line parallel to the longitudinal direction of the transistor pairs, and both of the second and fourth n-channel transistors ($QN_{20}$, $QN_{40}$) are formed to situate in another line parallel to the longitudinal direction of the transistor pairs.

11. A device as claimed in claim 9, wherein all of the second p-channel and n-channel transistors ($QP_{20}$, $QN_{20}$) and the fourth p-channel and n-channel transistors ($QP_{40}$, $QN_{40}$) are formed to situate in a common line parallel to the longitudinal direction of the transistor pairs.

12. A device as claimed in claim 11, wherein all of the second p-channel and n-channel transistors ($QP_{20}$, $QN_{20}$) and the fourth p-channel and n-channel transistors ($QP_{40}$, $QN_{40}$) are formed to situate in a common line passing through the midway between the two transistor pairs.

13. A device as set forth in claim 9, 10, 11 or 12, wherein the gates of the third p-channel and n-channel transistors ($QP_{30}$, $QN_{30}$) are commonly connected to each other by the same electrode material.

14. A device as claimed in claim 9, 10, 11, 12 or 13, wherein sources or drains of the first and third p-channel transistors ($QP_{10}$, $QP_{30}$) are formed in a single p-type region, and sources or drains of the first and third n-channel transistors ($QN_{10}$, $QN_{30}$) are formed in a single n-type region.

15. A device as claimed in claim 9, 10, 11, 12, 13 or 14, wherein, in each basic cell array, the gates of the fourth p-channel transistors in pairs of adjacent basic cells are commonly connected to one another by the same electrode material and the gates of fourth n-channel transistors in the same pairs of adjacent basic cell are commonly connected to each other by the same electrode material.

16. A device as claimed in claim 1, 2, or 3, further comprising:

at least a single $n^+$ region (4CN1, 4CN2) formed in the semiconductor substrate, adjacent to each of the first and second p-channel transistors; and

at least a single $p^+$ region (4CP1, 4CP2) formed in the semiconductor substrate, adjacent to each of the first and second n-channel transistors, wherein the $n^+$ and $p^+$ regions are for supplying portions of the semiconductor substrate with specified potentials.

17. A device as claimed in claim 4, 5 or 6, further comprising:

a single $n^+$ region formed in the semiconductor substrate adjacent to each of said first and third p-channel transistors;

another single $n^+$ region formed in the semiconductor substrate adjacent to each of the second and fourth p-channel transistors;

a single $p^+$ region formed in the semiconductor substrate adjacent to each of the first and third n-channel transistors; and

another single $p^+$ region formed in the semiconductor substrate adjacent to each of the second and fourth n-channel transistors, wherein the $n^+$ and $p^+$ regions are for supplying portions of the semiconductor substrate with specified potentials.

18. A device as claimed in claim 7 or 8, further comprising:

a single $n^+$ region formed in the semiconductor substrate intercepting (separating) the second p-channel transistor from the one longitudinal end of the transistor pair; and

a single $p^+$ region formed in the semiconductor substrate intercepting (separating) the second n-channel transistor from the other longitudinal end of the transistor pair, wherein the $n^+$ and $p^+$ regions are for supplying portions of the semiconductor substrate with specified potentials.

19. A device as claimed in claims 9, 10, 11, 12, 13, 14 or 15, further comprising:

a single $n^+$ region formed in the semiconductor substrate, intercepting (separating) the second p-channel transistor from the one longitudinal end of each of the transistor pairs; and

a single $p^+$ region formed in the semiconductor substrate intercepting (separating) the second n-channel transistor from the other longitudinal end of each of the transistor pairs,

wherein the $n^+$ and $p^+$ regions are for supplying portions of the semiconductor substrate with specified potentials.

20. A device as claimed in any preceding claim wherein the basic cell arrays are spaced by regions for distributing interconnecting lines therebetween.

**Patentansprüche**

1. Masterslice-Halbleitervorrichtung, mit oder ohne Verdrahtungsmuster, mit Basiszellen auf einem Halbleitersubstrat, welche Basiszellen längs Reihen und Spalten auf dem Halbleitersubstrat angeordnet sind, um eine Vielzahl von Basiszellengruppen zu bilden, von denen jede in Spaltenrichtung ausgerichtet ist, eine hinter der anderen in Reihenrichtung angeordnet ist, wobei jede Basiszelle umfaßt:

ein Transistorpaar mit einem ersten p-Kanal-Transistor ($QP_{10}$) und einen ersten n-Kanal-Transistor ($QN_{10}$), die nebeneinander ausgebildet sind, wobei die Gates des ersten p-Kanal-Transistors und des ersten n-Kanal-Transistors so gebildet sind, daß sie sich miteinander in einer Reihe erstrecken;

einen zweiten p-Kanal-Transistor ($QP_{20}$), der an einem longitudinalen Ende des Transistorpaares gebildet ist; und

einen zweiten n-Kanal-Transistor ($QN_{20}$), der an dem anderen longitudinalen Ende des Transistorpaares ausgebildet ist.

2. Vorrichtung nach Anspruch 1, bei der die Gates der zweiten p-Kanal- und n-Kanal-Transistoren ($QP_{20}$, $QN_{20}$) so gebildet sind, daß sie sich in einer Reihe mit der Reihe von Verlängerungen der Gates der ersten p-Kanal- und n-Kanal-Transistoren ($QP_{10}$, $QN_{10}$) erstrecken.

3. Vorrichtung nach Anspruch 1 oder 2, bei der die Gates der ersten p-Kanal- und n-Kanal-Transistoren ($QP_{10}$, $QN_{10}$) durch dasselbe Elektrodenmaterial miteinander verbunden sind.

4. Vorrichtung nach Anspruch 2 oder 3, bei der jede Basiszelle ferner umfaßt:

ein weiteres Transistorpaar, das einen dritten p-Kanal-Transistor ($QP_{30}$) und einen dritten n-Kanal-Transistor ($QN_{30}$) umfaßt, die jeweils parallel und benachbart zu den ersten p-Kanal- und n-Kanal-Transistoren ($QP_{10}$, $QN_{10}$) ausgerichtet sind, wobei die Gates der dritten p-Kanal- und n-Kanal-Transistoren ($QP_{30}$, $QN_{30}$) so geformt sind, daß sie sich miteinander in Reihe erstrecken;

einen vierten n-Kanal-Transistor ($QN_{40}$), der neben einem Längsend des weiteren Transistorpaares gebildet ist; und

einen vierten n-Kanal-Transistor ($QN_{40}$), der neben dem anderen Längsende des weiteren Transistorpaares gebildet ist; wobei die vierten p-Kanal- und n-Kanal-Transistoren ($QP_{40}$, $QN_{40}$) jeweils parallel und neben dem zweiten p-Kanal- und n-Kanal-Transistoren ($QP_{20}$, $QN_{20}$) ange-

ordnet sind, die Gates der vierten p-Kanal- und n-Kanal-Transistoren (QP$_{40}$, QN$_{40}$) sich in Reihe mit der Reihe der Verlängerungen der Gates der dritten p-Kanal- und n-Kanal-Transistoren (QP$_{30}$, QN$_{30}$) erstrecken.

5. Vorrichtung nach Anspruch 4, bei der die Gates der dritten p-Kanal- und n-Kanal-Transistoren (QP$_{30}$, QN$_{30}$) durch dasselbe Elektrodenmaterial miteinander verbunden sind.

6. Vorrichtung nach Anspruch 4 oder 5, bei der die Sourcen oder Drains der ersten und dritten p-Kanal-Transistoren (QP$_{10}$, QP$_{30}$) in einem einzigen p-Typ-Bereich (1) gebildet sind, und die Sourcen oder Drains der ersten und dritten n-Kanal-Transistoren (QN$_{10}$, QN$_{30}$) in einem einzigen n-Typ-Bereich (2) gebildet sind.

7. Vorrichtung nach Anspruch 1, bei der die Gates der zweiten p-Kanal- und n-Kanal-Transistoren (QP$_{20}$, QN$_{20}$) senkrecht zu der Reihe der Verlängerungen der Gates der ersten p-Kanal- und n-Kanal-Transistoren (QP$_{10}$, QN$_{10}$) ausgerichtet sind.

8. Vorrichtung nach Anspruch 7, bei der die Gates der ersten p-Kanal- und n-Kanal-Transistoren (QP$_{10}$, QN$_{10}$) durch dasselbe Elektrodenmaterial gemeinsam miteinander verbunden sind.

9. Vorrichtung nach Anspruch 7 oder 8, bei der jede Basiszelle ferner umfaßt:

ein weiteres Transistorpaar, das einen dritten p-Kanal-Transistor (QP$_{30}$) und einen dritten n-Kanal-Transistor (QN$_{30}$) umfaßt, die jeweils parallel und benachbart zu den ersten p-Kanal- und n-Kanal-Transistoren (QP$_{10}$, QN$_{10}$) ausgerichtet sind, wobei die Gates der dritten p-Kanal- und n-Kanal-Transistoren (QP$_{30}$, QN$_{30}$) so gebildet sind, daß sie sich in Reihe miteinander erstrecken;

einen vierten p-Kanal-Transistor (QP$_{40}$), der neben dem einem Längsende des weiteren Transistorpaares gebildet ist; und

einen vierten n-Kanal-Transistor (QN$_{40}$), der neben dem anderen Längsende des weiteren Transistorpaares gebildet ist; wobei die vierten p-Kanal- und n-Kanal-Transistoren jeweils parallel und neben den genannten zweiten p-Kanal- und n-Kanal-Transistoren (QP$_{20}$, QN$_{20}$) und die Gates der vierten p-Kanal- und vierten n-Kanal-Transistoren (QP$_{40}$, QN$_{40}$ so gebildet sind, daß sie sich senkrecht zu der Reihe der Verlängerungen der Gates der dritten p-Kanal- und n-Kanal-Transistoren (QP$_{30}$, QN$_{30}$) erstrecken.

10. Vorrichtung nach Anspruch 9, bei der beide der zweiten und vierten p-Kanal-Transistoren (QP$_{20}$, QP$_{40}$) so geformt sind, daß sie in einer Reihe parallel zu der Längsrichtung des Transistorpaares angeordnet sind, und beide der zweiten und vierten n-Kanal-Transistoren (QN$_{20}$, QN$_{40}$) so geformt sind, daß sie in einer anderen Reihe parallel zu der Längsrichtung des Transistorpaares angeordnet sind.

11. Vorrichtung nach Anspruch 9, bei der alle zweiten p-Kanal- und n-Kanal-Transistoren (QP$_{20}$, QN$_{20}$) und die vierten p-Kanal- und n-Kanal-Transistoren (QP$_{40}$, QN$_{40}$) so gebildet sind, daß sie in einer gemeinsamen Reihe parallel zu der Längsrichtung des Transistorpaares angeordnet sind.

12. Vorrichtung nach Anspruch 11, bei der alle zweiten p-Kanal- und n-Kanal-Transistoren (QP$_{20}$, QN$_{20}$) und die vierten p-Kanal- und n-Kanal-Transistoren (QP$_{40}$, QN$_{40}$) so gebildet sind, daß sie in einer gemeinsamen Reihe angeordnet sind, die durch die Mitte zwischen den beiden Transistorpaaren hindurchführt.

13. Vorrichtung nach Anspruch 9, 10, 11 oder 12, bei der die Gates der dritten p-Kanal- und n-Kanal-Transistoren (QP$_{30}$, QN$_{30}$) durch dasselbe Elektrodenmaterial gemeinsam miteinander verbunden sind.

14. Vorrichtung nach Anspruch 9, 10, 11, 12 oder 13, bei der Sourcen und Drains der ersten und dritten p-Kanal-Transistoren (QP$_{10}$, QP$_{30}$) in einem einzigen p-Typ-Bereich gebildet sind, und Sourcen oder Drains der ersten und dritten n-Kanal-Transistoren (QN$_{10}$, QN$_{30}$) in einem einzigen n-Typ-Bereich gebildet sind.

15. Vorrichtung nach Anspruch 9, 10, 11, 12, 13 oder 14, bei der, in jeder Basiszellengruppe, die Gates der vierten p-Kanal-Transistoren in Paaren von benachbarten Basiszellen gemeinsam miteinander durch dasselbe Elektrodenmaterial verbunden sind, und die Gates der vierten n-Kanal-Transistoren in denselben Paaren von benachbarten Basiszellen durch dasselbe Elektrodenmaterial gemeinsam miteinander verbunden sind.

16. Vorrichtung nach Anspruch 1, 2 oder 3, ferner mit:

mindestens einem einzelnen n$^+$-Bereich (4CN1, 4CN2), der in dem Halbleitersubstrat gebildet ist, neben jedem der ersten und zweiten p-Kanal-Transistoren; und

mindestens einem einzelnen p$^+$-Bereich (4CP1, 4CP2), der in dem Halbleitersubstrat gebildet ist, neben jedem der ersten und zweiten n-Kanal-Transistoren, wobei die n$^+$- und p$^+$-Bereiche zur Versorgung von Abschnitten des Halbleitersubstrats mit spezifizierten Potentialen dienen.

17. Vorrichtung nach Anspruch 4, 5 oder 6, ferner mit:

einen einzelnen n$^+$-Bereich, der in dem Halbleitersubstrat neben jedem der ersten und dritten p-Kanal-Transistoren gebildet ist;

einem anderen einzelnen n$^+$-Bereich, der in dem Halbleitersubstrat neben jedem der zweiten und vierten p-Kanal-Transistoren gebildet ist;

einem einzelnen p$^+$-Bereich, der in dem Halbleitersubstrat neben jedem der ersten und dritten n-Kanal-Transistoren gebildet ist; und

einem anderen einzelnen p$^+$-Bereich, der in dem Halbleitersubstrat neben jedem der zweiten und vierten n-Kanal-Transistoren gebildet ist, wobei die n$^+$- und p$^+$-Bereiche zur Versorgung von Abschnitten des Halbleitersubstrats mit spezifizierten Potentialen dienen.

18. Vorrichtung nach Anspruch 7 oder 8, ferner mit:

einem einzelnen n$^+$-Bereich, der in dem Halbleitersubstrat gebildet ist und den zweiten p-Kanal-Transistor von dem Längsende des Transistorpaares unterbricht (trennt); und

einem einzelnen p$^+$-Bereich, der in dem Halbleitersubstrat gebildet ist und den zweiten n-Kanal-Transistor von dem anderen Längsende des Transistorpaares unterbricht (trennt), wobei die n⁺- und p⁺-Bereiche zur Versorgung von Abschnitten des Halbleitersubstrats mit spezifizierten Potentialen dienen.

19. Vorrichtung nach Anspruch 9, 10, 11, 12, 13, 14 oder 15, ferner mit:

einem einzelnen n⁺-Bereich, der in dem Halbleitersubstrat gebildet ist, und den zweiten p-Kanal-Transistor von dem anderen Längsende von jedem der Transistorpaare unterbricht (trennt); und

einem einzelnen p⁺-Bereich, der in dem Halbleitersubstrat gebildet ist und den zweiten n-Kanal-Transistor von dem anderen Längsende von jedem der Transistorpaare unterbricht (trennt), wobei die n⁺- und p⁺-Bereiche zur Versorgung von Abschnitten des Halbleitersubstrates mit spezifizierten Potentialen dienen.

20. Vorrichtung nach einem der vorhergehenden Ansprüche, bei der die Basiszellengruppen durch Bereiche zur Verteilung von Zwischenverbindungsleitungen dazwischen beabstandet sind.

## Revendications

1. Un dispositif à semiconducteurs du type "masterslice", avec ou sans motifs d'interconnexion, comportant des cellules de base sur un substrat semiconducteur, avec les cellules de base disposées en rangées et en colonnes sur le substrat semiconducteur pour constituer un ensemble de réseaux de cellules de base, chacun d'eux étant aligné dans la direction des colonnes, qui sont disposés l'un après l'autre dans la direction des rangées, dans lequel chaque cellule de base comprend:

une paire de transistors comprenant un premier transistor à canal p ($QP_{10}$) et un premier transistor à canal n ($QN_{10}$) qui sont formés dans des positions mutuellement adjacentes, les grilles du premier transistor à canal p et du premier transistor à canal n étant formées de façon à s'étendre en alignement mutuel;

un second transistor à canal p ($QP_{20}$) qui est formé à une extrémité longitudinale de la paire de transistors; et

un second transistor à canal n ($QN_{20}$) qui est formé à l'autre extrémité longitudinale de la paire de transistors.

2. Un dispositif selon la revendication 1, dans lequel les grilles des seconds transistors à canal p et à canal n ($QP_{20}$, $QN_{20}$) sont formées de façon à s'étendre en alignement avec la ligne sur laquelle s'étendent les grilles des premiers transistors à canal p et à canal n ($QP_{10}$, $QN_{10}$).

3. Un dispositif selon la revendication 1 ou 2, dans lequel les grilles des premiers transistors à canal p et à canal n ($QP_{10}$, $QN_{10}$) sont mutuellement connectées en commun par le même matériau d'électrode.

4. Un dispositif selon la revendication 2 ou 3, dans lequel chaque cellule de base comprend en outre:

une paire de transistors supplémentaire comprenant un troisième transistor à canal p ($QP_{30}$) et un troisième transistor à canal n ($QN_{30}$, qui sont respectivement alignés de façon à être parallèles et adjacents aux premiers transistors à canal p et à canal n ($QP_{10}$, $QN_{10}$), les grilles des troisièmes transistors à canal p et à canal n ($QP_{30}$, $QN_{30}$) étant formées de façon à s'étendre en alignement mutuel;

un quatrième transistor à canal p ($QP_{40}$), formé en position adjacente à une extrémité longitudinal de la paire de transistors supplémentaire; et

un quatrième transistor à canal n ($QN_{40}$), formé en position adjacente à l'autre extrémité longitudinale de la paire de transistors supplémentaire; les quatrièmes transistors à canal p et à canal n ($QP_{40}$, $QN_{40}$) étant respectivement alignés de façon parallèle et adjacent aux seconds transistors à canal p et à canal n ($QP_{20}$, $QN_{20}$), et les grilles des quatrièmes transistors à canal p et à canal ($QP_{40}$, $QN_{40}$) s'étendant en alignement avec la ligne sur laquelle s'étendent les grilles des troisièmes transistors à canal p et à canal n ($QP_{30}$, $QN_{30}$).

5. Un dispositif selon la revendication 4, dans lequel les grilles des troisième transistors à canal p et à canal n ($QP_{30}$, $QN_{30}$) sont mutuellement connectées de façon commune par le même matériau d'électrode.

6. Un dispositif selon la revendication 4 ou 5, dans lequel les sources ou les drains des premier et troisième transistors à canal p ($QP_{10}$, $QP_{30}$) sont formés dans une seule région de type p (1), et les sources ou les drains des premier et troisième transistors à canal n ($QN_{10}$, $QN_{30}$) sont formés dans une seule région de type n (2).

7. Un dispositif selon la revendication 1, dans lequel les grilles des seconds transistors à canal p et à canal n ($QP_{20}$, $QN_{20}$) sont alignées dans une direction perpendiculaire à la ligne sur laquelle s'étendent les grilles des premiers transistors à canal p et à canal n ($QP_{10}$, $QN_{10}$).

8. Un dispositif selon la revendication 7, dans lequel les grilles des premiers transistors à canal p et à canal n ($QP_{10}$, $QN_{10}$) sont connectées mutuellement en commun par le même matériau d'électrode.

9. Un dispositif selon la revendication 7 ou 8, dans lequel chaque cellule de base comprend en outre:

une paire de transistors supplémentaire comprenant un troisième transistor à canal p ($QP_{30}$) et un troisième transistor à canal n ($QN_{30}$), qui sont respectivement alignés de façon parallèle et adjacenet aux premiers transistors à canal p et à canal n ($QP_{10}$, $QN_{10}$), les grilles des troisièmes transistors à canal p et à canal n ($QP_{30}$, $QN_{30}$) étant formées de façon à s'étendre en alignement mutuel;

un quatrième transistor à canal p ($QP_{40}$) qui est formé au voisinage d'une extrémité longitudinal de la paire de transistors supplémentaire; et

un quatrième transistor à canal n ($QN_{40}$) formé au voisinage de l'autre extrémité longitudinale de la paire de transistors supplémentaire; et dans lequel les quatrièmes transistors à canal p et à canal n sont respectivement alignés de façon parallèle et adjacente aux seconds transistors à canal p et à canal n ($QP_{20}$, $QN_{20}$), et les grilles des quatrièmes transistors à canal p et à canal n ($QP_{40}$, $QN_{40}$) sont formées de façon à s'étendre perpendiculairement à la ligne sur laquelle s'étendent les grilles des troisièmes transistors à canal p et à canal n ($QP_{30}$, $QN_{30}$).

10. Un dispositif selon la revendication 9, dans lequel les second et quatrième transistors à canal p ($QP_{20}$, $QP_{40}$) sont formés de façon à se trouver sur une ligne qui est parallèle à la direction longitudinale des paires de transistors, et les second et quatrième transistors à canal n ($QN_{20}$, $QN_{40}$) sont formés de façon à se trouver sur une autre ligne parallèle à la direction longitudinale des paires de transistors.

11. Un dispositif selon la revendication 9, dans lequel les seconds transistors à canal p et à canal n ($QP_{20}$, $QN_{20}$) et les quatrièmes transistors à canal p et à canal n ($QP_{40}$, $QN_{40}$) sont tous formés de façon à se trouver sur une ligne commune parallèle à la direction longitudinale des paires de transistors.

12. Un dispositif selon la revendication 11, dans lequel les seconds transistors à canal p et à canal n ($QP_{20}$, $QN_{20}$) et les quatrièmes transistors à canal p et à canal n ($QP_{40}$, $QN_{40}$) sont tous formés de façon à se trouver sur une ligne commune qui passe en position médiane entre les deux paires de transistors.

13. Un dispositif selon la revendication 9, 10, 11 ou 12, dans lequel les grilles des troisièmes transistors à canal p et à canal n ($QP_{30}$, $QN_{30}$) sont connectées mutuellement en commun par le même matériau d'électrode.

14. Un dispositif selon la revendication 9, 10, 11, 12 ou 13, dans lequel les sources ou les drains des premier et troisième transistors à canal p ($QP_{10}$, $QP_{30}$) sont formés dans une seule région de type p, et les sources ou les drains des premier et troisième transistors à canal n ($QN_{10}$, $QN_{30}$) sont formés dans une seule région de type n.

15. Un dispositif selon la revendication 9, 10, 11, 12, 13 ou 14, dans lequel, dans chaque réseau de cellules de base, les grilles des quatrièmes transistors à canal p dans des paires de cellules de base adjacentes sont mutuellement connectées en commun par le même matériau d'électrode, et les grilles des quatrièmes transistors à canal n dans les mêmes paires de cellules de base adjacentes sont mutuellement connectées en commun par le même matériau d'électrode.

16. Un dispositif selon la revendication 1, 2 ou 3, comprenant en outre:
au moins une seule région $n^+$ (4CN1, 4CN2) formée dans le substrat semiconducteur, en position adjacente à chacun des premier et second transistors à canal p; et
au moins une seule région $p^+$ (4CP1, 4CP2) formée dans le substrat semiconducteur, en position adjacente à chacun des premier et second transistors à canal n, dans lequel les régions $n^+$ et $p^+$ sont destinées à l'application de potentiels spécifiés à des parties du substrat semiconducteur.

17. Un dispositif selon la revendication 4, 5 ou 6, comprenant en outre:
une région $n^+$ unique formée dans le substrat semiconducteur en position adjacente à chacun des premier et troisième transistors à canal p;
une autre région $n^+$ unique formée dans le substrat semiconducteur en position adjacente à chacun des second et quatrième transistors à canal p;
une région $p^+$ unique formée dans le substrat semiconducteur en position adjacente à chacun des premier et troisième transistors à canal n; et
une autre région $p^+$ unique formée dans le substrat semiconducteur en position adjacente à chacun des second et quatrième transistors à canal n, dans lequel les régions $n^+$ et $p^+$ sont destinées à l'application de potentiels spécifiés à des parties du substrat semiconducteur.

18. Un dispositif selon la revendication 7 ou 8, comprenant en outre:
une région $n^+$ unique formée dans le substrat semiconducteur et séparant le second transistor à canal p de l'extrémité longitudinale mentionnée en premier de la paire de transistors; et
une région $p^+$ unique formée dans le substrat semiconducteur et séparant le second transistor à canal n de l'autre extrémité longitudinale de la paire de transistors, dans lequel les régions $n^+$ et $p^+$ sont destinées à l'application de potentiels spécifiés à des parties du substrat semiconducteur.

19. Un dispositif selon les revendications 9, 10, 11, 12, 13, 14 ou 15, comprenant en outre:
une région $n^+$ unique formée dans le substrat semiconducteur et séparant le second transistor à canal p de l'extrémité longitudinale mentionnée en premier de chacune des paires de transistors; et
une région $p^+$ unique formée dans le substrat semiconducteur et séparent le second transistor à canal n de l'autre extrémité longitudinale de chacune des paires de transistors,
dans lequel les régions $n^+$ et $p^+$ sont destinées à l'application de potentiels spécifiés à des parties du substrat semiconducteur.

20. Un dispositif selon l'une quelconque des revendications précédentes, dans lequel les réseaux de cellules de base sont séparés par des régions prévues pour la répartition de lignes d'interconnexion entre ces réseaux.

*FIG. 1*

## FIG. 2

## FIG. 3

# FIG. 4

*FIG. 5*

QP20    QP10    QN10    QN20

*FIG. 6 (a)*

4CN2    4CN1    4CP1    4CP2

3G13 QP20 31   3G11 QP10 11   3G12 QN10 12   32 QN20 3G14

*FIG.6 (b)*

4CN2    4CN1    4CP1    4CP2

31 3G13 QP20   3G11 QP10 11   3G12 QN10 12   QN20 3G14 32

FIG. 7

FIG. 8

FIG. 9

FIG. 10

## FIG. 11

CK

QP40

Ao ———————— oX

QN40

CK

## FIG. 12

BC1    CK    A    CK    BC2

QN20    QN40    QP40    QP20

X

## FIG. 13

## FIG. 14

# FIG. 15

*FIG. 16*

## FIG. 17

## FIG. 18

## FIG.19

BL1        BL2

QN20  QN40    QP40 QP20

}BC11

}BC12

QN20  QN40    QP40 QP20

## FIG.20

BL'

BL1        BL2

UC